# EUROPEAN PATENT APPLICATION

(11) **EP 4 770 394 A1**
(43) Date of publication of application: **01.07.2026**
(21) Application number: 25213519.9
(22) Date of filing: 04.11.2025
(51) Int. Cl.: H10K 59/80, H10K 59/121, H10K 59/126

(54) **DISPLAY APPARATUS HAVING A LIGHT-EMITTING DEVICE AND A PIXEL LENS**

(30) Priority: 26.12.2024 KR 20240197246
(71) Applicant: LG Display Co., Ltd., Seoul, 07336 (KR)
(72) Inventor: JIN, You Yong, 10845 Paju-si, Gyeonggi-do (KR); LEE, Young Bok, 10845 Paju-si, Gyeonggi-do (KR); OH, Se Wan, 10845 Paju-si, Gyeonggi-do (KR); KI, Seok Ho, 10845 Paju-si, Gyeonggi-do (KR)
(74) Representative: Bryn-Jacobsen, Caelia

(57) **Abstract**

A display apparatus presented herein includes a device substrate on which a plurality of pixels are disposed, a first light-emitting device overlapping a first emission area included in a pixel area of each pixel, an upper barrier pattern disposed on the first light-emitting device and comprising an upper opening, and a pixel lens disposed on the upper barrier pattern and overlapping the upper opening of the upper barrier pattern. The first emission area can at least partially overlap the upper opening of the upper barrier pattern. A virtual center line passing through a lens central point of the pixel lens in a direction perpendicular to the device substrate toward the upper barrier pattern can be located outside the first emission area. The quality of an image provided by the display apparatus to a user located obliquely with respect to the display panel is improved.

## Description

### CROSS-REFERENCE TO RELATED APPLICATION

The present application claims priority to Republic of Korea Patent Application No. 10-2024-0197246, filed on December 26, 2024.

### FIELD

The present disclosure relates to a display apparatus in which a pixel lens is disposed on a light-emitting device.

### BACKGROUND

Generally, a display apparatus provides an image to a user. For example, the display apparatus can include a light-emitting device. The light-emitting device can emit light of a specific color. For example, the light-emitting device can include a light-emitting unit disposed between a first electrode and a second electrode.

A pixel lens can be disposed on the light-emitting device. Light emitted from the light-emitting device can be focused by the pixel lens. For example, a surface of the pixel lens opposite to the light-emitting device can have a convex shape. Thus, in the display apparatus, the quality of the image provided to the user can be improved.

### SUMMARY

Accordingly, the present disclosure is directed to a display apparatus that substantially obviates one or more problems due to limitations and disadvantages of the related art.

An object of the present disclosure is to provide a display device in which an image provided to a user can't be recognized by people located in a different direction from the user.

Another object of the present disclosure is to provide a display device capable of improving the quality of the image provided in an inclined direction.

Additional advantages, objects, and features of the disclosure will be set forth in part in the description which follows and in part will become apparent to those having ordinary skill in the art upon examination of the following or may be learned from practice of the disclosure. The objectives and other advantages of the disclosure may be realized and attained by the structure particularly pointed out in the written description and claims hereof as well as the appended drawings.

To achieve these objects and other advantages and in accordance with the purpose of the present disclosure, as embodied and broadly described herein, there is provided a display apparatus comprising a device substrate on which a plurality of pixels are disposed; a first light-emitting device overlapping a first emission area included in a pixel area of each of the pixels; an upper barrier pattern disposed on the first light-emitting device and comprising an upper opening; and a pixel lens disposed on the upper barrier pattern and overlapping the upper opening of the upper barrier pattern. The first emission area can at least partially overlap the upper opening of the upper barrier pattern. A virtual center line passing through a lens central point of the pixel lens in a third direction perpendicular to the device substrate toward the upper barrier pattern can be located outside the first emission area.

In a plane of the device substrate, the virtual center line can be spaced apart from the first emission area in a first direction, and each of the first emission area, the upper opening and the pixel lens can have a bar shape extending in a second direction perpendicular to the first direction.

In a plane of the device substrate, the upper opening of the upper barrier pattern can have a symmetrical shape with respect to an axis passing through the lens central point in the second direction.

A cross-section of the pixel lens in the third direction can have a semi-circular shape.

A lower surface of the pixel lens toward the device substrate can have a larger size than the upper opening of the upper barrier pattern.

A lower barrier pattern can be disposed above the first light-emitting device and below the upper barrier pattern. The lower barrier pattern can include a lower opening overlapping the upper opening and the pixel lens. The upper opening can have a smaller size than the lower opening.

A second emission area can be included in the pixel area of each of the pixels, and the second emission area can display a same color as the first emission area. A second light-emitting device can be disposed between the device substrate and the upper barrier pattern. The second light-emitting device can overlap the second emission area. The second emission area can at least partially overlap the upper opening of the upper barrier pattern. The virtual center line can be located between the first emission area and the second emission area.

In a plane of the device substrate, the first emission area can have a shape symmetrical to the second emission area with respect to the axis passing through the lens central point in the second direction.

A planarization layer can be disposed between the device substrate and the first light-emitting device and between the device substrate and the second light-emitting device. A first driving circuit and a second driving circuit can be disposed between the device substrate and the planarization layer. The first driving circuit can be electrically connected to the first light-emitting device. The second driving circuit can be electrically connected to the second light-emitting device. The first driving circuit and the second driving circuit can be disposed in the pixel area and insulated from each other.

The second driving circuit can have a same configuration as the first driving circuit.

A first image realized by a first light emitted from the first emission area of each of the pixels can contain different information from a second image realized by a second light emitted from the second emission area of each of the pixels.

In one or more examples, there is provided a display apparatus comprising a device substrate on which a plurality of pixels are disposed, wherein a pixel area of each of the pixels includes a first emission area and a second emission area; an upper barrier pattern comprising a plurality of upper openings, wherein each of the upper openings at least partially overlaps the first emission area and the second emission area of one of the pixels; and a plurality of pixel lenses disposed on the upper barrier pattern, wherein each of the pixel lenses overlaps one of the upper openings of the upper barrier pattern. In the pixel area of each of the pixels, a lens central point of the pixel lens can be located between the first emission area and the second emission area in a first direction. In a plane of the device substrate, a spacing between adjacent pixel lenses in the first direction can be the same as a spacing between adjacent pixel lenses in a second direction perpendicular to the first direction, and a spacing between adjacent pixel lenses in a direction inclined to the first direction and the second direction can be smaller than the spacing between adjacent pixel lenses in the second direction.

In one or more examples, there is provided a display apparatus comprising a device substrate on which a plurality of pixels are disposed, wherein a pixel area of each of the pixels includes a first emission area and a second emission area; a plurality of touch electrodes, wherein a space between adjacent touch electrodes at least partially overlaps the first emission area and the second emission area of one of the pixels; and a plurality of pixel lenses disposed on the plurality of touch electrodes, wherein each of the pixel lenses overlaps the space between adjacent touch electrodes. In the pixel area of each pixel, a lens central point of the pixel lens can be located between the first emission area and the second emission area in a first direction. In a plane of the device substrate, a spacing between adjacent pixel lenses in the first direction can be the same as a spacing between adjacent pixel lenses in a second direction perpendicular to the first direction, and a spacing between adjacent pixel lenses in a direction inclined to the first direction and the second direction can be smaller than the spacing between adjacent pixel lenses in the second direction.

In the pixel area of each of the pixels, the second emission area can have a same length as the first emission area in the first direction and the second direction.

In the pixel area of each of the pixels, the first emission area and the second emission area can be disposed side by side in a direction inclined to the first direction and the second direction.

The plurality of pixels can comprise a first pixel, a second pixel, and a third pixel that display different colors. A pixel area of the second pixel can be disposed side by side with a pixel area of the first pixel in a direction inclined to the first direction and the second direction. A pixel area of the third pixel can be disposed side by side with the pixel area of the first pixel in the first direction. The pixel area of the first pixel can be repeatedly disposed in the second direction.

A barrier passivation layer can be disposed between the upper barrier pattern and the pixel lenses.

In one or more examples, there is provided a vehicle that comprises the display apparatus as described above. The display apparatus can be disposed in front of a driver seat and a passenger seat.

### BRIEF DESCRIPTION OF THE DRAWINGS

The accompanying drawings, which are included to provide a further understanding of the present disclosure and are incorporated in and constitute a part of this application, illustrate example(s) of the present disclosure and together with the description serve to explain the principle of the present disclosure. In the drawings:
FIG. 1 is a view schematically showing a location where a display apparatus is installed according to one or more examples of the present disclosure.
FIG.2 is a view showing a plane of a display panel in the display apparatus according to one or more examples of the present disclosure.
FIG. 3 is an enlarged view of K region in FIG. 2.
FIG. 4 is a view showing a driving circuit of a sub-pixel in a display panel of the display apparatus according to one or more examples of the present disclosure.
FIG. 5 is a view taken along line I-I' of FIG. 3.
FIG. 6 is a view showing a luminance graph according to a viewing angle of a first light emitted from a first emission area of each pixel area and a luminance graph according to a viewing angle of a second light emitted from a second emission area of each pixel area in the display apparatus according to one or more examples of the present disclosure.
FIG. 7 is a view showing a cross-section of the display panel in the display apparatus according to one or more examples of the present disclosure.
FIG. 8 is a view showing a plane of the display panel in the display apparatus according to one or more examples of the present disclosure.
FIG. 9 is a view taken along line II-II' of FIG. 8.
FIG. 10 is a view taken along line III-III' of FIG. 8.
FIGS. 11 to 12 are views showing a display apparatus according to one or more examples of the present disclosure.
FIG. 13 is a view showing a plane of the display panel in the display apparatus according to one or more examples of the present disclosure.
FIG. 14 is a view taken along line IV-IV' of FIG. 13.

### DETAILED DESCRIPTION

Hereinafter, details related to the above objects, technical configurations, and operational effects of the examples of the present disclosure will be clearly understood by the following detailed description with reference to the drawings, which illustrate some examples of the present disclosure. Here, the examples of the present disclosure are provided in order to allow the technical sprit of the present disclosure to be satisfactorily transferred to those skilled in the art, and thus the present disclosure may be embodied in other forms and is not limited to the examples described below.

In addition, the same or extremely similar elements may be designated by the same reference numerals throughout the specification and in the drawings, the lengths and thickness of layers and regions may be exaggerated for convenience. It will be understood that, when a first element is referred to as being "on" a second element, although the first element may be disposed on the second element so as to come into contact with the second element, a third element may be interposed between the first element and the second element.

Here, terms such as, for example, "first" and "second" may be used to distinguish any one element with another element. However, the first element and the second element may be arbitrary named according to the convenience of those skilled in the art without departing the technical sprit of the present disclosure.

The terms used in the specification of the present disclosure are merely used in order to describe particular examples, and are not intended to limit the scope of the present disclosure. For example, an element described in the singular form is intended to include a plurality of elements unless the context clearly indicates otherwise. In addition, in the specification of the present disclosure, it will be further understood that the terms "comprises" and "includes" specify the presence of stated features, integers, steps, operations, elements, components, and/or combinations thereof, but do not preclude the presence or addition of one or more other features, integers, steps, operations, elements, components, and/or combinations thereof.

And, unless 'directly' is used, the terms "connected" and "coupled" may include that two components are "connected" or "coupled" through one or more other components located between the two components.

Unless otherwise defined, all terms (including technical and scientific terms) used herein have the same meaning as commonly understood by one of ordinary skill in the art to which examples belong. It will be further understood that terms, such as those defined in commonly used dictionaries, should be interpreted as having a meaning that is consistent with their meaning in the context of the relevant art and should not be interpreted in an idealized or overly formal sense unless expressly so defined herein.

### Example

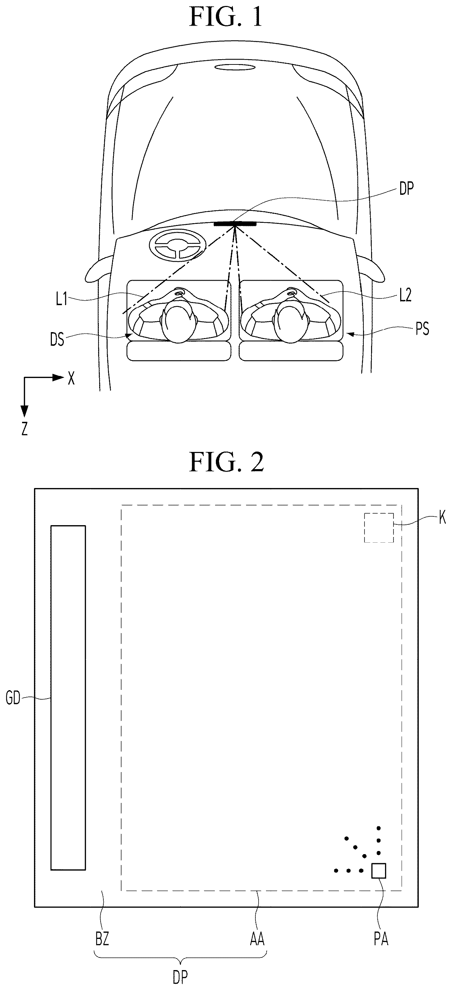

FIG. 1 is a view schematically showing a location where a display apparatus is installed according to one or more examples of the present disclosure.

Referring to FIG. 1, the display apparatus according to one or more examples of the present disclosure can include a display panel DP installed in a car. The display panel DP can provide an image to a driver sitting in a driver seat DS and/or a passenger sitting in a passenger seat PS. For example, the display panel DP can be disposed between the driver seat DS and the passenger seat PS. The driver sitting in the driver seat DS and the passenger sitting in the passenger seat PS can be located in a direction inclined to the display panel DP.

The display panel DP can provide the passenger sitting in the passenger seat PS with an image different from the driver sitting in the driver seat DS. For example, the display panel DP can provide a first image containing information necessary for the operation of the car to the driver sitting in the driver seat DS and a second image containing information unrelated to the operation of the car to the passenger sitting in the passenger seat PS.

The display panel DP can realize the first image and the second image, simultaneously. For example, a first light L1 for realizing the first image and a second light L2 for realizing the second image can be emitted simultaneously from the display panel DP. The first light L1 can't travel in a direction toward the passenger seat PS, and the second light L2 can't travel in a direction toward the driver seat DS. For example, the first image by the first light L1 can't be recognized by the passenger sitting in the passenger seat PS, and the second image by the second light L2 can't be recognized by the driver sitting in the driver seat DS. Thus, in the display apparatus according to one or more examples of the present disclosure, the visibility of the first image and the visibility of the second image can be improved. And, in the display apparatus according to one or more examples of the present disclosure, gaze dispersion of the driver due to the second image can be prevented. Therefore, in the display apparatus according to one or more examples of the present disclosure, the accidents due to gaze dispersion of the driver while driving the car can be reduced.

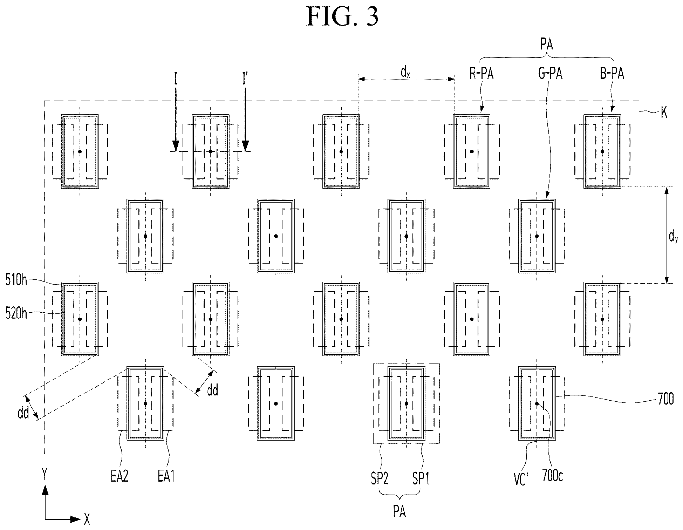

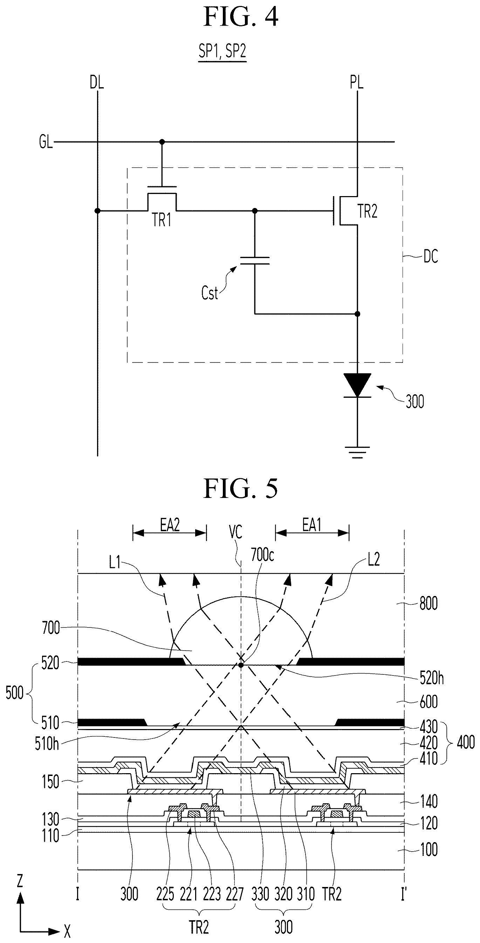

FIG.2 is a view showing a plane of a display panel in the display apparatus according to one or more examples of the present disclosure. FIG. 3 is an enlarged view of K region in FIG. 2. FIG. 4 is a view showing a driving circuit of a sub-pixel in a display panel of the display apparatus according to one or more examples of the present disclosure. FIG. 5 is a view taken along line I-I' of FIG. 3.

Referring to FIGS. 1 to 5, the display apparatus according to one or more examples of the present disclosure can include pixel areas PA within the display panel DP. The pixel areas PA can be arranged in a matrix shape. For example, the pixel areas PA can be disposed side by side in a first direction X and a second direction Y perpendicular to the first direction X. Herein, for example, the first direction X can mean a direction from the driver seat DS to the passenger seat PS, the second direction Y can be a direction perpendicular to the first direction X in the plane of the display panel DP, and a third direction Z perpendicular to the first direction X and the second direction Y can be a direction perpendicular to the plane of the display panel DP and toward the driver seat DS and the passenger seat PS.

Each of the pixel areas PA can display a specific color. For example, the pixel area PA can include red pixel areas R-PA realizing a red color, green pixel areas G-PA realizing a green color, and blue pixel areas B-PA realizing a blue color. Thus, in the display apparatus according to one or more examples of the present disclosure, the image having various colors can be realized by the pixel areas PA.

Each of the pixel areas PA can include a first sub-pixel SP1 and a second sub-pixel SP2 disposed side by side with the first sub-pixel SP1 in the first direction X. For example, the second sub-pixel SP2 of each pixel area PA can be disposed closer to the driver seat DS than the first sub-pixel SP1 of the corresponding pixel area PA. The second sub-pixel SP2 of each pixel area PA can realize a same color as the first sub-pixel SP1 of the corresponding pixel area PA. For example, the first sub-pixel SP1 and the second sub-pixel SP2 of each blue pixel area B-PA can realize a blue color.

A driving circuit DC electrically connected to signal wirings GL, DL and PL and a light-emitting device 300 electrically connected to the driving circuit DC can be disposed in each sub-pixel SP1 and SP2. The second sub-pixel SP2 of each pixel area PA can be formed by a same process as the first sub-pixel SP1 of the corresponding pixel area PA. For example, the driving circuit DC of the second sub-pixel SP2 in each pixel area PA can have a same configuration as the driving circuit DC of the first sub-pixel SP1 in the corresponding pixel area PA.

The signal wirings GL, DL and PL can include a gate line GL applying a gate signal, a data line DL applying a data signal, and a power voltage supply line PL supplying a power voltage. For example, the driving circuit DC can supply a driving current corresponding to the data signal to the light-emitting device 300 according to the gate signal using the power voltage. The driving current supplied to the light-emitting device 300 by the driving circuit DC can be maintained for one frame. For example, the driving circuit DC can include a first thin film transistor TR1, a second thin film transistor TR2 and a storage capacitor Cst.

The first thin film transistor TR1 can transmit the data signal to the second thin film transistor TR2 according to the gate signal. For example, the first thin film transistor TR1 can function as a switching thin film transistor. The first thin film transistor TR1 can include a first semiconductor pattern, a first gate electrode, a first drain electrode and a first source electrode. For example, the first gate electrode can be electrically connected to the gate line GL, and the first drain electrode can be electrically connected to the data line DL.

The second thin film transistor TR2 can generate the driving current according to the data signal using the power voltage. For example, the second thin film transistor TR2 can function as a driving thin film transistor. The second thin film transistor TR2 can include a second semiconductor pattern 221, a second gate electrode 223, a second drain electrode 225 and a second source electrode 227. For example, the second gate electrode 223 can be electrically connected to the first source electrode, and the second drain electrode 225 can be electrically connected to the power voltage supply line PL.

A voltage of a signal applied to the second gate electrode 223 can be maintained for one frame by the storage capacitor Cst. The storage capacitor Cst can have a stacked structure of capacitor electrodes. For example, the storage capacitor Cst can have a structure in which a first capacitor electrode electrically connected to the second gate electrode 223 and second capacitor electrode electrically connected to the second source electrode 227 are stacked.

The driving circuit DC of each sub-pixel SP1 and SP2 can be supported by a device substrate 100. The device substrate 100 can include an insulating material. For example, the device substrate 100 can include glass or plastic. At least one insulating layers 110, 120, 130, 140 and 150 for preventing unnecessary electrical connection can be disposed on the device substrate 100. For example, a buffer insulating layer 110, a gate insulating layer 120, an interlayer insulating layer 130, a device planarization layer 140 and a bank insulating layer 150 can be disposed on the device substrate 100.

The buffer insulating layer 110 can prevent pollution due to the device substrate 100 in a process of forming the driving circuit DC of each sub-pixel SP1 and SP2. For example, an upper surface of the device substrate 100 toward the driving circuit DC of each sub-pixel SP1 and SP2 can be covered by the buffer insulating layer 110. The driving circuit DC of each sub-pixel SP1 and SP2 can be disposed on the buffer insulating layer 110.

The gate insulating layer 120 can be disposed on the buffer insulating layer 110. The second gate electrode 223 of each sub-pixel SP1 and SP2 can be insulated from the second semiconductor pattern 221 of the corresponding sub-pixel SP1 and SP2 by the gate insulating layer 120. For example, the first semiconductor pattern and the second semiconductor pattern 221 of each sub-pixel SP1 and SP2 can be covered by the gate insulating layer 120.

The interlayer insulating layer 130 can be disposed on the gate insulating layer 120. The second drain electrode 225 and the second source electrode 227 of each sub-pixel SP1 and SP2 can be insulated from the second gate electrode 223 of the corresponding sub-pixel SP1 and SP2 by the interlayer insulating layer 130. For example, the first gate electrode and the second gate electrode 223 of each sub-pixel SP1 and SP2 can be covered by the interlayer insulating layer 130 on the gate insulating layer 120.

The device planarization layer 140 can be disposed on the interlayer insulating layer 130. The first drain electrode, the first source electrode, the second drain electrode 225 and the second source electrode 227 of each sub-pixel SP1 and SP2 can be covered by the device planarization layer 140 on the interlayer insulating layer 130. A thickness difference due to the driving circuit DC of each sub-pixel SP1 and SP2 can be removed by the device planarization layer 140. For example, an upper surface of the device planarization layer 140 opposite to the device substrate 100 can be flat. The device planarization layer 140 can include a material having a higher fluidity than the buffer insulating layer 110, the gate insulating layer 120 and the interlayer insulating layer 130. For example, the buffer insulating layer 110, the gate insulating layer 120 and the interlayer insulating layer 130 can be an inorganic insulating layer made of an inorganic insulating material, and the device planarization layer 140 can be an organic insulating layer made of an organic insulating material.

The light-emitting device 300 of each sub-pixel SP1 and SP2 can be disposed on the upper surface of the device planarization layer 140. The light-emitting device 300 of each sub-pixel SP1 and SP2 can emit light of a specific color. For example, the light-emitting device 300 of each sub-pixel SP1 and SP2 can include a first electrode 310, a light-emitting unit 320 and a second electrode 330, which are sequentially stacked on the device planarization layer 140.

The first electrode 310 and the second electrode 330 can include a conductive material. The second electrode 330 can include a different material from the first electrode 310. For example, a transmittance of the second electrode 330 can be higher than a transmittance of the first electrode 310. The first electrode 310 can have a higher reflectance than the second electrode 330. For example, the first electrode 310 can be a reflective electrode including a metal, such as aluminum (Al) and silver (Ag), and the second electrode 330 can be a transparent electrode made of a transparent conductive material, such as ITO and IZO.

The light-emitting unit 320 can generate light having luminance corresponding to a voltage difference between the first electrode 310 and the second electrode 330. For example, the light-emitting unit 320 can include at least one emission material layer (EML). The light-emitting unit 320 can have a multi-layer structure. For example, the light-emitting unit 320 can further include at least one of a hole injection layer (HIL), a hole transport layer (HTL), an electron transport layer (ETL) and an electron injection layer (EIL). The light generated by the light-emitting unit 320 can be emitted through the second electrode 330.

The first electrode 310 of each sub-pixel SP1 and SP2 can be electrically connected to the driving circuit DC of the corresponding sub-pixel SP1 and SP2. For example, the first electrode 310 of each sub-pixel SP1 and SP2 can be in direct contact with the second source electrode 227 of the corresponding sub-pixel SP1 and SP2 by penetrating the device planarization layer 140. A connection point between the second source electrode 227 and the first electrode 310 in each sub-pixel SP1 and SP2 can be covered by the bank insulating layer 150.

The bank insulating layer 150 disposed on the device planarization layer 140 can partially expose the first electrode 310 of each sub-pixel SP1 and SP2. For example, an edge of the first electrode 310 in each sub-pixel SP1 and SP2 can be covered by the bank insulating layer 150. The bank insulating layer 150 can include an insulating material. For example, the first electrode 310 of the second sub-pixel SP2 can be insulated from the first electrode 310 of the first sub-pixel SP1 by the bank insulating layer 150. The light-emitting unit 320 of each sub-pixel SP1 and SP2 can be in direct contact with a portion of the first electrode 310 exposed by the bank insulating layer 150 in the corresponding sub-pixel SP1 and SP2. That is, in the display apparatus according to one or more examples of the present disclosure, an emission area EA1 and EA2 in which light is emitted can be defined in each sub-pixel SP1 and SP2 by the bank insulating layer 150. A portion of the device substrate 100 overlapping with the bank insulating layer 150 can be defined as a non-emission area in which light is not emitted. For example, in the display apparatus according to one or more examples of the present disclosure, a first emission area EA1 can be defined in the first sub-pixel SP1 of each pixel area PA, a second emission area EA2 can be defined in the second sub-pixel SP2 of each pixel area PA, and the non-emission area can be disposed between the first emission area EA1 and the second emission area EA2 of each pixel area PA.

The second emission area EA2 of each pixel area PA can have a same size as the first emission area EA1 of the corresponding pixel area PA. For example, the second emission area EA2 of each pixel area PA can have a same length as the first emission area EA1 of the corresponding pixel area PA in the first direction X and the second direction Y. The second emission area EA2 of each pixel area PA can have a planar shape same as the first emission area EA1 of the corresponding pixel area PA. For example, each of planes of the first emission area EA1 and the second emission area EA2 defined in each pixel area PA can have a shape of a bar extending in the second direction Y.

The first light L1 for realizing the first image can be emitted from the first emission area EA1 of each pixel area PA, and the second light L2 for realizing the second image can be emitted from the second emission area EA2 of each pixel area PA. The second light L2 emitted from the second emission area EA2 of each pixel area PA can have a same color as the first light L1 emitted from the first emission area EA1 of the corresponding pixel area PA. For example, the light-emitting unit 320 in the second emission area EA2 of each pixel area PA can be formed simultaneously with the light-emitting unit 320 in the first emission area EA1 of the corresponding pixel area PA.

A signal applied to the second electrode 330 on the second sub-pixel SP2 of each pixel area PA can be a same as a signal applied to the second electrode 330 on the first sub-pixel SP1 of the corresponding pixel area PA. For example, the second electrode 330 on the second sub-pixel SP2 of each pixel area PA can be electrically connected to the second electrode 330 on the first sub-pixel SP1 of the corresponding pixel area PA. The second electrode 330 on the second sub-pixel SP2 of each pixel area PA can be in direct contact with the second electrode 330 on the first sub-pixel SP1 of the corresponding pixel area PA. The driving circuit DC in the second sub-pixel SP2 of each pixel area PA can be insulated from the driving circuit DC in the first sub-pixel SP1 of the corresponding pixel area PA. Thus, in the display apparatus according to one or more examples of the present disclosure, the luminance of the first light L1 emitted from the first emission area EA1 of each pixel area PA can be adjusted by the data signal applied to the first sub-pixel SP1 of the corresponding pixel area PA, and the luminance of the second light L2 emitted from the second emission area EA2 of each pixel area PA can be adjusted by the data signal applied to the second sub-pixel SP2 of the corresponding pixel area PA. Therefore, in the display apparatus according to one or more examples of the present disclosure, the first image realized by the first light L1 emitted from the first emission area EA1 of each pixel area PA can contain different information from the second image realized by the second light L2 emitted from the second emission area EA2 of each pixel area PA.

An encapsulation structure 400 can be disposed on the light-emitting devices 300 of each pixel area PA. The encapsulation structure 400 can prevent the damage of the light-emitting devices 300 due to external impact and moisture. For example, the light-emitting devices 300 of each pixel area PA can be completely covered by the encapsulation structure 400. The encapsulation structure 400 can include a region overlapping with the first emission area EA1 of each pixel area PA, a region overlapping with the second emission area EA2 of each pixel area PA, and a region overlapping with the non-emission area. The encapsulation structure 400 can have a multi-layer structure. For example, the encapsulation structure 400 can include a first encapsulating layer 410, a second encapsulating layer 420 and a third encapsulating layer 430, which are sequentially stacked. The second encapsulating layer 420 can include a material having a higher fluidity than the first encapsulating layer 410 and the third encapsulating layer 430. For example, the first encapsulating layer 410 and the third encapsulating layer 430 can be an inorganic encapsulating layer made of an inorganic insulating material, and the second encapsulating layer 420 can be an organic encapsulating layer made of an organic insulating material. A thickness difference due to the light-emitting devices 300 of each pixel area PA can be removed by the second encapsulating layer 420.

A barrier structure 500 can be disposed on an upper surface of the encapsulation structure 400 opposite to the device substrate 100. The barrier structure 500 can have a multi-layer structure. For example, the barrier structure 500 can have a stacked structure of a lower barrier pattern 510 and an upper barrier pattern 520.

The lower barrier pattern 510 can be disposed close to the encapsulation structure 400. For example, a lower surface of the lower barrier pattern 510 toward the device substrate 100 can be in direct contact with the upper surface of the encapsulation structure 400. The lower barrier pattern 510 can include a material capable to blocking light. For example, the lower barrier pattern 510 can include a black dye, such as carbon black.

The lower barrier pattern 510 can include lower openings 510h. Each of the lower openings 510h can overlap one of the pixel areas PA. Thus, in the display apparatus according to one or more examples of the present disclosure, the second light L2 emitted from the second emission area EA2 of each pixel area PA can be emitted passing through the lower opening 510h same as the first light L1 emitted from the first emission area EA1 of the corresponding pixel area PA. Therefore, in the display apparatus according to one or more examples of the present disclosure, a travelling direction of the first light L1 emitted from the first emission area EA1 of each pixel area PA and a travelling direction of the second light L2 emitted from the second emission area EA2 of the corresponding pixel area PA can be firstly limited by the lower barrier pattern 510.

The lower opening 510h of each pixel area PA can be disposed between the first emission area EA1 and the second emission area EA2 defined in the corresponding pixel area PA. Each of the first emission area EA1 and the second emission area EA2 defined in each pixel area PA can partially overlap the lower opening 510h of the corresponding pixel area PA. For example, a portion of the first emission area EA1 disposed close to the second emission area EA2 and a portion of the second emission area EA2 disposed close to the first emission area EA1 in each pixel area PA can overlap the lower opening 510h of the corresponding pixel area PA. The lower opening 510h of each pixel area PA can have a planar shape corresponding to the first emission area EA1 and the second emission area EA2 of the corresponding pixel area PA. For example, a plane of the lower opening 510h on each pixel area PA can have a shape of a bar extending in the second direction Y. Thus, in the display apparatus according to one or more examples of the present disclosure, the first light L1 emitted from the first emission area EA1 of each pixel area PA can travel in a direction toward the driver seat DS by passing through one of the lower openings 510h, and the second light L2 emitted from the second emission area EA2 of each pixel area PA can travel in a direction toward the passenger seat PS by passing through one of the lower openings 510h.

A portion of the second emission area EA2 overlapping with the lower opening 510h in each pixel area PA can have a same size as a portion of the first emission area EA1 overlapping with the lower opening 510h in the corresponding pixel area PA. For example, the second emission area EA2 of each pixel area PA can be symmetrical to the first emission area EA1 of the corresponding pixel area PA with respect to an axis VC' passing through a lens central point 700c of the pixel lens 700 in the second direction Y, as shown in FIG. 3. Thus, in the display apparatus according to one or more examples of the present disclosure, the second image by the second light L2 of each pixel area PA can have a same quality as the first image by the first light L1 of the corresponding pixel area PA.

Each of the first emission area EA1 and the second emission area EA2 defined in each pixel area PA can include a region that does not overlap the lower opening 510h on the corresponding pixel area PA. For example, a portion of the first emission area EA1 disposed far from the second emission area EA2 and a portion of the second emission area EA2 disposed far from the first emission area EA1 in each pixel area PA can overlap the lower barrier pattern 510. Thus, in the display apparatus according to one or more examples of the present disclosure, the light emitted from the first emission area EA1 of each pixel area PA toward the passenger seat PS and the light emitted from the second emission area EA2 of each pixel area PA toward the driver seat DS can be blocked by the lower barrier pattern 510. That is, in the display apparatus according to one or more examples of the present disclosure, the first light L1 of each pixel area PA for realizing the first image can't be recognized by the passenger sitting in the passenger seat PS, and the second light L2 of each pixel area PA for realizing the second image can't be recognized by the driver sitting in the driver seat DS. Therefore, in the display apparatus according to one or more examples of the present disclosure, the visibility of the first image provided to the driver sitting in the driver seat DS by the first light L1 and the visibility of the second image provided to the passenger sitting in the passenger seat PS by the second light L2 can be improved. And, in the display apparatus according to one or more examples of the present disclosure, gaze dispersion of the driver due to the second image can be prevented.

The upper barrier pattern 520 can be disposed on the lower barrier pattern 510. The upper barrier pattern 520 can be spaced apart from the lower barrier pattern 510. For example, the lower barrier pattern 510 can be covered by an optical insulating layer 600, and the upper barrier pattern 520 can be disposed on an upper surface of the optical insulating layer 600 opposite to the device substrate 100. The optical insulating layer 600 can include a transparent material. For example, the optical insulating layer 600 can include an organic insulating material. The first emission area EA1 and the second emission area EA2 of each pixel area PA can overlap the optical insulating layer 600. The optical insulating layer 600 can extend onto the non-emission area. For example, the lower openings 510h of the lower barrier pattern 510 can be filled by the optical insulating layer 600.

The upper barrier pattern 520 can be disposed close to the upper surface of the optical insulating layer 600. For example, a lower surface of the upper barrier pattern 520 toward the device substrate 100 can be in direct contact with the upper surface of the optical insulating layer 600. The upper barrier pattern 520 can include a material capable of blocking light. For example, the upper barrier pattern 520 can include a black dye, such as carbon black. The upper barrier pattern 520 can include a same material as the lower barrier pattern 510.

The upper barrier pattern 520 can include upper openings 520h. The upper openings 520h can overlap the lower openings 510h. For example, each of the upper openings 520h can overlap one of the pixel areas PA. Thus, in the display apparatus according to one or more examples of the present disclosure, the second light L2 emitted from the second emission area EA2 of each pixel area PA can pass through the upper opening 520h same as the first light L1 emitted from the first emission area EA1 of the corresponding pixel area PA. That is, in the display apparatus according to one or more examples of the present disclosure, the travelling direction of the first light L1 emitted from the first emission area EA1 of each pixel area PA and the travelling direction of the second light L2 emitted from the second emission area EA2 of the corresponding pixel area PA can be secondly limited by the upper barrier pattern 520.

The upper opening 520h of each pixel area PA can have a planar shape corresponding to the lower opening 510h of the corresponding pixel area PA. For example, a plane of the upper opening 520h on each pixel area PA can have a shape of a bar extending in the second direction Y. The center of the upper opening 520h on each pixel area PA can coincide with the center of the lower opening 510h on the corresponding pixel area PA. The upper opening 520h of each pixel area PA can have a smaller size than the lower opening 510h of the corresponding pixel area PA. Thus, in the display apparatus according to one or more examples of the present disclosure, some of the light passing through the lower opening 510h of each pixel area PA can be blocked by the upper barrier pattern 520. For example, in the display apparatus according to one or more examples of the present disclosure, the center of the first emission area EA1 and the center of the second emission area EA2 in each pixel area PA can be disposed outside the upper opening 520h of the corresponding pixel area PA, and the light emitted from the first emission area EA1 of each pixel area PA in a direction perpendicular to the upper surface of the device substrate 100 and the light emitted from the second emission area EA2 of each pixel area PA in a direction perpendicular to the upper surface of the device substrate 100 can be partially blocked by the upper barrier pattern 520. Therefore, in the display apparatus according to one or more examples of the present disclosure, the visibility of the first image and the visibility of the second image can be effectively improved. And, in the display apparatus according to one or more examples of the present disclosure, gaze dispersion of the driver due to the second image can be effectively prevented.

Pixel lenses 700 can be disposed on the upper barrier pattern 520. Each of the pixel lenses 700 can overlap one of the upper openings 520h. For example, the first light L1 and the second light L2 passing through the upper opening 520h of each pixel area PA can be focused by the pixel lens 700 on the corresponding pixel area PA. The pixel lens 700 of each pixel area PA can function as a convex lens. For example, a surface of each pixel lens 700 opposite to the device substrate 100 can have a convex shape.

The pixel lens 700 of each pixel area PA can have a planar shape corresponding to the upper opening 520h of the corresponding pixel area PA. For example, a plane of the pixel lens 700 on each pixel area PA can have a shape of a bar extending in the second direction Y. The pixel lens 700 of each pixel area PA can have a larger size than the upper opening 520h of the corresponding pixel area PA. For example, the upper opening 520h of each pixel area PA can be filled by the pixel lens 700 of the corresponding pixel area PA. An edge of the pixel lens 700 on each pixel area PA can overlap the upper barrier pattern 520. Thus, in the display apparatus according to one or more examples of the present disclosure, the light extraction of the first light L1 and the second light L2 of each pixel area PA can be improved. The pixel lens 700 of each pixel area PA can have a smaller size than the lower openings 510h of the corresponding pixel area PA.

A lens central point 700c of the pixel lens 700 on each pixel area PA can coincide with the center of the upper opening 520h on the corresponding pixel area PA, in a plan view. For example, a virtual center line VC passing through the lens central point 700c of each pixel area PA in a direction perpendicular to the upper surface of the device substrate 100 can be disposed between the first emission area EA1 and the second emission area EA2 of the corresponding pixel area PA in the first direction X. A plane of the upper opening 520h on each pixel area PA can have a symmetric shape with respect to the axis VC' passing through the lens central point 700c in the second direction Y. Thus, in the display apparatus according to one or more examples of the present disclosure, the deviation in the quality between the first image and the second image due to the pixel lens 700 of each pixel area PA can be prevented.

A lens planarization layer 800 can be disposed on the pixel lens 700 of each pixel area PA. The lens planarization layer 800 can prevent the damage of the pixel lens 700 on each pixel area PA due to the external impact. For example, the pixel lens 700 of each pixel area PA can be completely covered by the lens planarization layer 800. The lens planarization layer 800 can extend onto an upper surface of the upper barrier pattern 520 opposite to the device substrate 100. For example, the lens planarization layer 800 can include a region overlapping with the pixel lenses 700 and a region overlapping with the upper barrier pattern 520.

The lens planarization layer 800 can include an insulating material. For example, the lens planarization layer 800 can be an organic insulating material. A thickness difference due to the pixel lenses 700 can be removed by the lens planarization layer 800. For example, an upper surface of the lens planarization layer 800 opposite to the device substrate 100 can be flat. The lens planarization layer 800 can have a refractive index smaller than the pixel lens 700 of each pixel area PA. For example, the light passing through the pixel lens 700 of each pixel area PA can be focused due to a difference in refractive index between the pixel lens 700 of the corresponding pixel area PA and the lens planarization layer 800.

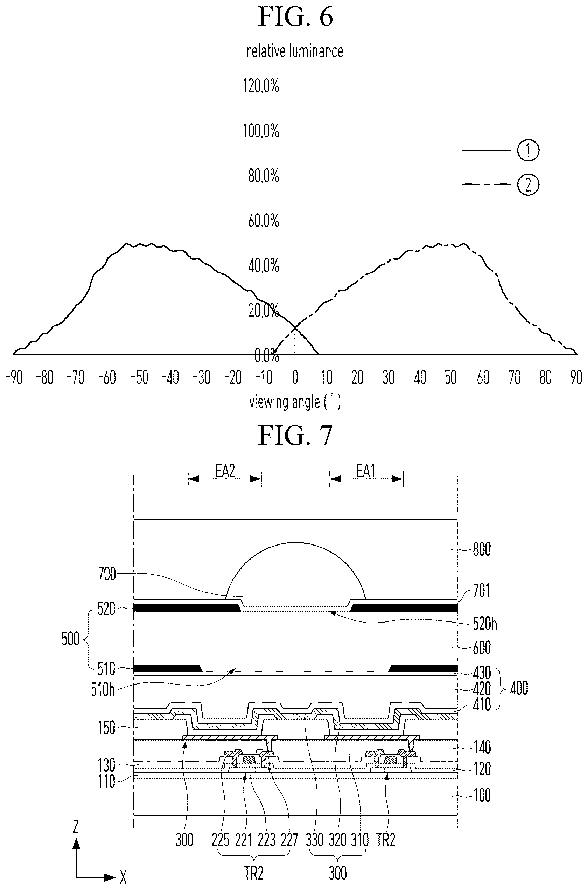

FIG. 6 is a view showing a luminance graph ① according to a viewing angle of the first light L1 emitted from the first emission area EA1 of each pixel area PA and a luminance graph ② according to a viewing angle of the second light L2 emitted from the second emission area EA2 of each pixel area PA in the display apparatus according to one or more examples of the present disclosure.

Referring to FIG. 6, in the display apparatus according to one or more examples of the present disclosure, by properly setting the refractive index of the pixel lens 700, the first light L1 of each pixel area PA can have the maximum luminance at a viewing angle of -40° to -60°, and the second light L2 of each pixel area PA can have the maximum luminance at a viewing angle of 40° to 60°. That is, in the display apparatus according to one or more examples of the present disclosure, the first light L1 recognized by the driver sitting in the driver seat DS can have the maximum luminance, and the second light L2 recognized by the passenger sitting in the passenger seat PS can have the maximum luminance. Thus, in the display apparatus according to one or more examples of the present disclosure, the quality of the first image provided to the driver sitting in the driver seat DS by the first light L1 emitted from the first emission area EA1 of each pixel area PA, and the quality of the second image provided to the passenger sitting in the passenger seat PS by the second light L2 emitted from the second emission area EA2 of each pixel area PA can be improved.

Referring to FIG. 6, in the display apparatus according to one or more examples of the present disclosure, the first light L1 of each pixel area PA can't be recognized at a viewing angle of 10° to 90°, and the second light L2 of each pixel area PA can't be recognized at a viewing angle of -90° to -10°. Thus, in the display apparatus according to one or more examples of the present disclosure, the second light L2 emitted from the second emission area EA2 of each pixel area PA can't be recognized by the driver sitting in the driver seat DS, and the first light L1 emitted from the first emission area EA1 of each pixel area PA can't be recognized by the passenger sitting in the passenger seat PS. Therefore, in the display apparatus according to one or more examples of the present disclosure, the visibility of the first image and the visibility of the second image can be improved. And, in the display apparatus according to one or more examples of the present disclosure, gaze dispersion of the driver due to the second image can be prevented.

Accordingly, the display apparatus according to one or more examples of the present disclosure can include the bank insulating layer 150, the light-emitting devices 300, the lower barrier pattern 510, the upper barrier pattern 520 and the pixel lenses 700, wherein the bank insulating layer 150 can define the first emission area EA1 and the second emission area EA2 in each pixel area PA, wherein the lower barrier pattern 510 and the upper barrier pattern 520 can respectively include openings 510h and 520h overlapping with the pixel area PA, wherein each of the pixel lenses 700 can overlap one of the lower openings 510h of the lower barrier pattern 510 and one of the upper openings 520h of the upper barrier pattern 520, and wherein the virtual center line VC passing through the lens central point 700c of each pixel lens 700 in a direction perpendicular to the upper surface of the device substrate 100 can be disposed between the first emission area EA1 and the second emission area EA2 of one of the pixel areas PA. Thus, in the display apparatus according to one or more examples of the present disclosure, the travelling direction of the first light L1 emitted from the first emission area EA1 defined in each pixel area PA can be limited toward the driver seat DS by the lower barrier pattern 510, the upper barrier pattern 520 and the pixel lenses 700, and the travelling direction of the second light L2 emitted from the second emission area EA2 defined in each pixel area PA can be limited toward the passenger seat PS by the lower barrier pattern 510, the upper barrier pattern 520 and the pixel lenses 700. That is, in the display apparatus according to one or more examples of the present disclosure, the first light L1 for realizing the first image can't be recognized by the passenger sitting in the passenger seat PS, and the second light L2 for realizing the second image can't be recognized by the driver sitting in the driver seat DS. Therefore, in the display apparatus according to one or more examples of the present disclosure, the visibility of the first image and the second image can be improved, and gaze dispersion of the driver due to the second image can be prevented.

And, in the display apparatus according to one or more examples of the present disclosure, the first light L1 emitted from the first emission area EA1 of each pixel area PA can have the maximum luminance in a direction toward the driver seat DS, and the second light L2 emitted from the second emission area EA2 of each pixel area PA can have the maximum luminance in a direction toward the passenger seat PS. Thus, in the display apparatus according to one or more examples of the present disclosure, the quality of the first image provided to the driver sitting in the driver seat DS by the first light L1 and the quality of the second image provided to the passenger sitting in the passenger seat PS by the second light L2 can be improved. Therefore, in the display apparatus according to one or more examples of the present disclosure, the power consumption for realizing the first image and the power consumption for realizing the second image can be reduced. That is, in the display apparatus according to one or more examples of the present disclosure, the low-power operation can be possible, and the power consumption can be reduced.

In the display apparatus according to one or more examples of the present disclosure, the display panel DP can include a display area AA in which the pixel areas PA are disposed, and a bezel area BZ disposed outside the display area AA, as shown in FIG. 2. The bezel area BZ can extend along an edge of the display area AA. For example, the display area AA can be surrounded by the bezel area BZ. A gate driver GD electrically connected to the gate line GL, a data driver electrically connected to the data line DL, and a power unit electrically connected to the power voltage supply line PL can be disposed outside the display area AA. At least one of the gate driver GD, the data driver and the power unit can be disposed on the bezel area BZ. For example, the display apparatus according to one or more examples of the present disclosure can be a GIP (Gate In Panel) type display apparatus in which the gate driver GD is formed on the bezel area BZ.

In the display apparatus according to one or more examples of the present disclosure, each of the pixel areas PA can display a different color from the pixel area PA adjacent in the first direction X, as shown in FIG. 3. For example, in the display apparatus according to one or more examples of the present disclosure, the red pixel areas R-PA, the green pixel areas G-PA and the blue pixel areas B-PA can be repeatedly arranged in the first direction X. The pixel areas PA can be arranged staggered from each other. For example, the arrangement of the pixel areas PA in the first direction X can have a zigzag shape. Each of the pixel areas PA can display a same color as the pixel area PA adjacent in the second direction Y. For example, in the display apparatus according to one or more examples of the present disclosure, the pixel areas PA can include the red pixel areas R-PA disposed side by side in the second direction Y, the green pixel areas G-PA disposed side by side with each red pixel area R-PA in a direction inclined to the first direction X and the second direction Y, and the blue pixel areas B-PA disposed side by side with each red pixel area R-PA in the first direction X.

The pixel areas PA can have a constant interval in the first direction X and the second direction Y. For example, a spacing dy between the pixel lenses 700 adjacent in the second direction Y can be the same as a spacing dx between the pixel lenses 700 adjacent in the first direction X. A spacing dd between the pixel lenses 700 adjacent in a direction inclined to the first direction X and the second direction Y can be a smaller than the spacing dy between the pixel lenses 700 adjacent in the second direction Y. That is, in the display apparatus according to one or more examples of the present disclosure, the spacing between the pixel areas PA in the first direction X and the second direction Y can be increased by the arrangement of the pixel areas PA having a zigzag shape. Thus, in the display apparatus according to one or more examples of the present disclosure, the interference between the first light L1 of each pixel area PA and the second light L2 of the pixel area PA adjacent the corresponding pixel area PA in the first direction X can be reduced. Therefore, in the display apparatus according to one or more examples of the present disclosure, the quality of the first image by the first light L1 of each pixel area PA and the quality of the second image by the second light L2 of each pixel area PA can be effectively improved.

In the display apparatus according to one or more examples of the present disclosure, a size of the first emission area EA1 defined in each pixel area PA and a size of the second emission area EA2 defined in each pixel area PA can be increased. Thus, in the display apparatus according to one or more examples of the present disclosure, the amount of the first light L1 provided to the driver sitting in the driver seat DS by the first emission area EA1 of each pixel area PA and the amount of the second light L2 provided to the passenger sitting in the passenger seat PS by the second emission area EA2 of each pixel area PA can be increased. Therefore, in the display apparatus according to one or more examples of the present disclosure, the visibility of the first image by the first light L1 and the visibility of the second image by the second light L2 can be effectively improved.

The display apparatus according to one or more examples of the present disclosure is described that each of the first emission area EA1 and the second emission area EA2 defined in each pixel area PA can partially overlap the lower opening 510h and the upper openings 520h of the corresponding pixel area PA, such that a travelling direction of the first light L1 emitted from the first emission area EA1 and a travelling direction of the second light L2 emitted from the second emission area EA2 can be limited by the lower barrier pattern 510 and the upper barrier pattern 520. However, in the display apparatus according to one or more other examples of the present disclosure, each of the first emission area EA1 and the second emission area EA2 in each pixel area PA can completely overlap with the lower opening 510h or the upper openings 520h. For example, in the display apparatus according to one or more other examples of the present disclosure, each of the first emission area EA1 in each pixel area PA can be completely exposed by the lower opening 510h, such that the travelling direction of the first light L1 cannot be limited by the lower barrier pattern510.

The upper opening 520h and the pixel lens 700 can be completely overlap the first emission area EA1 in each pixel area PA. For example, in the display apparatus according to one or more other examples of the present disclosure, the first light L1 can travel in a direction toward the driver seat DS, and the second light L2 can travel in a direction toward the passenger seat PS by refraction of the pixel lens 700. That is, in the display apparatus according to one or more other examples of the present disclosure, the travelling the first light L1 and the travelling direction of the second light L2 cannot be limited by the lower barrier pattern 510 and the upper barrier pattern 520. Therefore, in the display apparatus according to one or more other examples of the present disclosure, the degree of freedom in the locations of the first emission area EA1 and the second emission area EA2 of each pixel area PA can be improved.

The display apparatus according to one or more examples of the present disclosure is described that the driving circuit DC consists of the first thin film transistor TR1, the second thin film transistor TR2 and the storage capacitor Cst. However, in the display apparatus according to one or more other examples of the present disclosure, the driving circuit DC can include a driving thin film transistor and at least one switching thin film transistors. For example, in the display apparatus according to one or more other examples of the present disclosure, the driving circuit DC can further include a third thin film transistor to initialize the storage capacitor Cst according to the gate signal. The third thin film transistor can include a third semiconductor pattern, a third gate electrode, a third drain electrode and a third source electrode. For example, the third gate electrode can be electrically connected to the gate line GL, the third drain electrode can be electrically connected to an initial line applying an initialization signal to the storage capacitor Cst, and the third source electrode can be electrically connected to the storage capacitor Cst. Thus, in the display apparatus according to one or more other examples of the present disclosure, the degree of freedom in the configuration of the driving circuit DC can be improved.

In the display apparatus according to one or more examples of the present disclosure, the location and the electric connection of the first drain electrode, the first source electrode, the second drain electrodes 225 and the second source electrode 227 in each driving circuit DC can vary depending on the configuration of the corresponding driving circuit DC and/or the type of the corresponding thin film transistors TR1 and TR2. For example, in the display apparatus according to one or more other examples of the present disclosure, the second gate electrode 223 can be electrically connected to the first drain electrode. Thus, in the display apparatus according to one or more other examples of the present disclosure, the degree of freedom in the configuration of each driving circuit DC and the type of each thin film transistor TR1 and TR2 can be improved.

The display apparatus according to one or more examples of the present disclosure is described that the display panel DP is disposed only between the driver seat DS and the passenger seat PS. However, in the display apparatus according to one or more other examples of the present disclosure, the display panel DP can extend in the first direction X. For example, in the display apparatus according to one or more other examples of the present disclosure, an integrated display panel DP including a region disposed in front of the driver seat DS, a region disposed between the driver seat DS and the passenger seat PS, and a region disposed in front of the passenger seat PS can be used. Thus, in the display apparatus according to one or more other examples of the present disclosure, the degree of freedom in the location and the shape of the display panel DP can be improved.

The display apparatus according to one or more examples of the present disclosure is described that a single display panel DP is used. However, in the display apparatus according to one or more other examples of the present disclosure, a plurality of display panels DP can be used. For example, in the display apparatus according to one or more other examples of the present disclosure, the plurality of display panel DP can include a first display panel installed in front of the driver seat DS, a second display panel installed in front of the passenger seat PS, and a third display panel installed between the driver seat DS and the passenger seat PS. The first display panel, the second display panel and the third display panel can have a same structure. The first display panel, the second display panel and the third display panel can be separated from each other. For example, the first display panel, the second display panel and the third display panel can realize different images. Thus, in the display apparatus according to one or more other examples of the present disclosure, the different images can be provided to people located in various directions.

The display apparatus according to one or more examples of the present disclosure is described that a lower surface of each pixel lens 700 toward the device substrate 100 is in direct contact with the upper surface of the optical insulating layer 600 in the upper opening 520h of one of the pixel areas PA. However, in the display apparatus according to one or more other examples of the present disclosure, at least one insulating layer can be disposed between the optical insulating layer 600 and the pixel lenses 700. For example, in the display apparatus according to one or more other examples of the present disclosure, the upper barrier pattern 520 can be covered by a barrier passivation layer 701, and the pixel lens 700 of each pixel area PA can be disposed on the barrier passivation layer 701, as shown in FIG. 7. The barrier passivation layer 701 can include an insulating material. The barrier passivation layer 701 can include a different material from the optical insulating layer 600. For example, the barrier passivation layer 701 can be an inorganic insulating layer made of an inorganic insulating material. Thus, in the display apparatus according to one or more other examples of the present disclosure, the deformation of the pixel lenses 700 due to moisture and/or oxygen moved through the optical insulating layer 600 can be prevented. Therefore, in the display apparatus according to one or more other examples of the present disclosure, the deviation in the luminance due to shape difference of the pixel lenses 700 can be prevented.

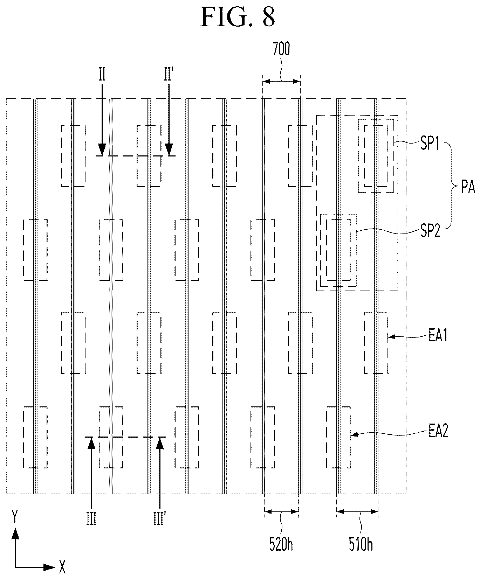

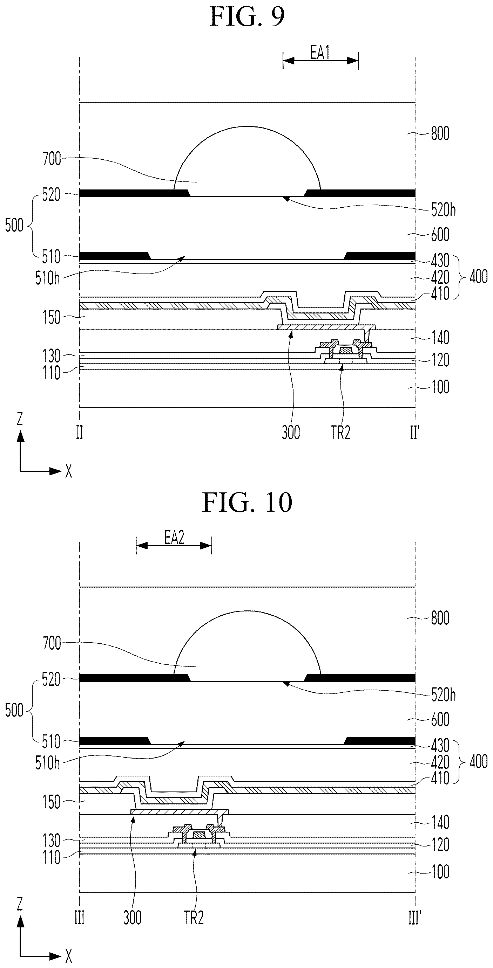

The display apparatus according to one or more examples of the present disclosure is described that the arrangement of the red pixel area R-PA, the green pixel area G-PA and the blue pixel area B-PA which are disposed adjacent to each other has a triangular shape in a plan view. However, in the display apparatus according to one or more other examples of the present disclosure, the first emission area EA1 and the second emission area EA2 of each pixel area PA can share the pixel lens 700 on the corresponding pixel area PA in various ways. For example, in the display apparatus according to one or more other examples of the present disclosure, each of the lower openings 510h, the upper openings 520h and the pixel lenses 700 can extend in the second direction Y, the pixel areas PA can be disposed side by side in the first direction X and the second direction Y, and the first emission area EA1 and the second emission area EA2 of each pixel area PA can be disposed side by side in a direction inclined to the first direction X and the second direction Y, as shown in FIGS. 8 to 10. That is, in the display apparatus according to one or more other examples of the present disclosure, the second emission area EA2 of each pixel area PA can be spaced apart from the first emission area EA1 of the corresponding pixel area PA in the first direction X and the second direction Y. Thus, in the display apparatus according to one or more other examples of the present disclosure, the interference between the first light L1 of each pixel area PA and the second light L2 of the pixel area PA adjacent the corresponding pixel area PA can be effectively reduced.

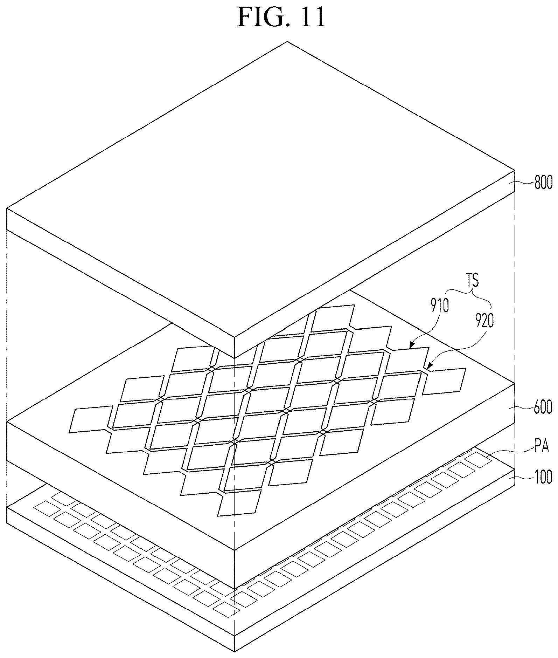

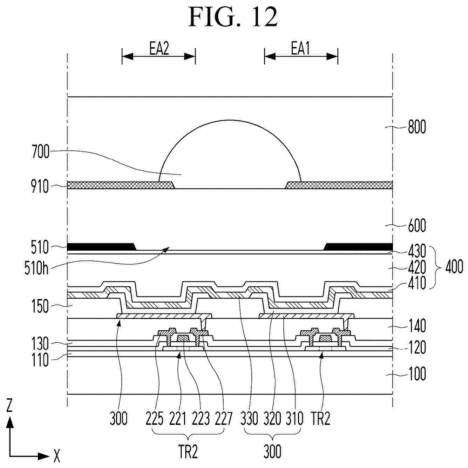

The display apparatus according to one or more examples of the present disclosure is described that the upper barrier pattern 520 includes a same material as the lower barrier pattern 510. However, in the display apparatus according to one or more other examples of the present disclosure, the upper barrier pattern 520 can include a different material from the lower barrier pattern 510. For example, in the display apparatus according to one or more other examples of the present disclosure, a touch sensor TS for sensing a touch of the user or a tool can be disposed between the optical insulating layer 600 and the lens planarization layer 800, as shown in FIGS. 11 and 12.

The touch sensor TS can include touch electrodes 910 and bridge electrodes 920 connecting between the touch electrodes 910. The touch electrodes 910 and the bridge electrode 920 can include a conductive material. The touch electrodes 910 and the bridge electrode 920 can include a material capable of blocking light. For example, the touch electrodes 910 and the bridge electrodes 920 can include a metal. At least some of the bridge electrodes 920 can include a different material from the touch electrodes 910. For example, at least some of the bridge electrode 920 can be disposed on a different layer from the touch electrodes 910.

A lower surface of each touch electrode 910 toward the device substrate 100 can be in direct contact with the upper surface of the optical insulating layer 600. For example, the touch electrodes 910 can be disposed between the optical insulating layer 600 and the lens planarization layer 800. The touch electrodes 910 can be disposed outside the first emission area EA1 and the second emission area EA2 defined in each pixel area PA. For example, the touch electrodes 910 can be disposed in the non-emission area. An edge of each pixel lens 700 can overlap one of the touch electrodes 910. The touch electrodes 910 can overlap the lower barrier pattern 510. The travelling direction of the light passing through each lower opening 510h can be limited by the touch electrodes 910. For example, in the display apparatus according to one or more other examples of the present disclosure, the touch electrodes 910 can function as the upper barrier pattern. A space between the touch electrodes 910 can function as the upper opening 520h. That is, in the display apparatus according to one or more other examples of the present disclosure, a process of forming the upper barrier pattern can be omitted. Therefore, in the display apparatus according to one or more other examples of the present disclosure, the process efficiency can be improved.

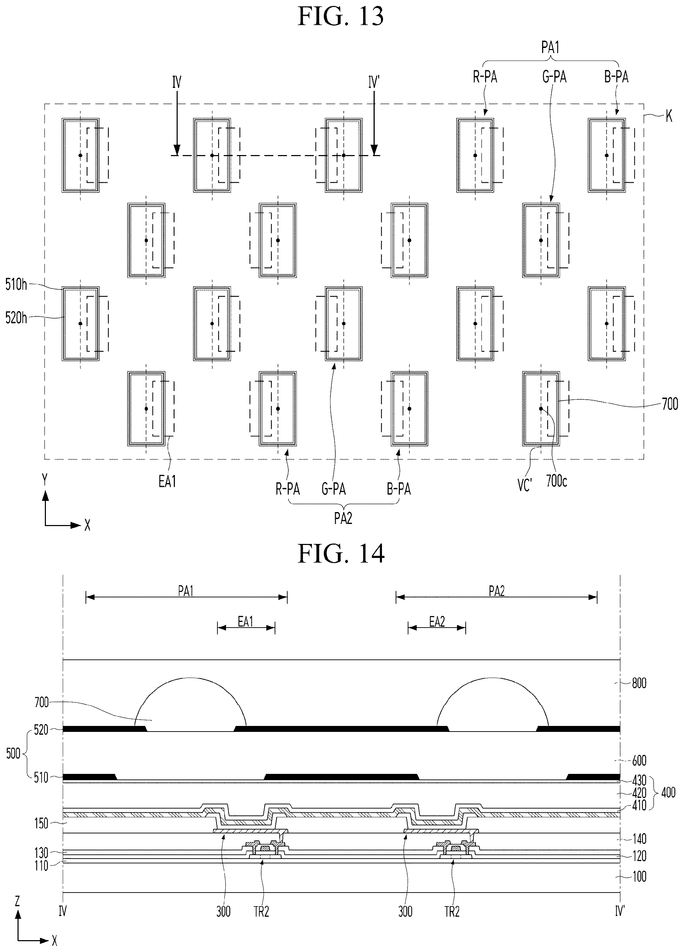

The display apparatus according to one or more examples of the present disclosure is described that each of the pixel areas PA includes both the first emission area EA1 and the second emission area EA2. However, in the display apparatus according to one or more other examples of the present disclosure, each of the pixel areas PA can include only one emission area EA1 and EA2. For example, in the display apparatus according to one or more other examples of the present disclosure, the pixel areas PA can include first pixel areas PA1 including only the first emission area EA1, and second pixel areas PA2 including only the second emission area EA2, as shown in FIGS. 13 and 14.

In the display apparatus according to one or more other examples of the present disclosure, an image by the first pixel areas PA1 or the second pixel areas PA2 can be provided to only one of the driver and the passenger. For example, in the display apparatus according to one or more other examples of the present disclosure, the first image provided to the driver sitting in the driver seat DS can be realized by the first pixel areas PA1, and the second image provided to the passenger sitting in the passenger seat PS can be realized by the second pixel areas PA2.

The first pixel areas PA1 and the second pixel areas PA2 can be repeatedly arranged in the first direction X. Thus, in the display apparatus according to one or more other examples of the present disclosure, a difference in the luminance between the first image and the second image. Therefore, in the display apparatus according to one or more other examples of the present disclosure, the degree of freedom in the configuration and the location of the pixel areas PA can be improved.

Further examples are set out in the clauses below:
1. A display apparatus, comprising:
   a device substrate on which a plurality of pixels are disposed;
   a first light-emitting device overlapping a first emission area included in a pixel area of each of the plurality of pixels;
   an upper barrier pattern disposed on the first light-emitting device, the upper barrier pattern comprising an upper opening; and
   a pixel lens disposed on the upper barrier pattern, the pixel lens overlapping the upper opening of the upper barrier pattern,
   wherein the first emission area at least partially overlaps the upper opening of the upper barrier pattern, and
   wherein a virtual center line passing through a lens central point of the pixel lens in a third direction perpendicular to the device substrate toward the upper barrier pattern is located outside the first emission area.
2. The display apparatus according to clause 1, wherein in a plane of the device substrate, the virtual center line is spaced apart from the first emission area in a first direction, and each of the first emission area, the upper opening and the pixel lens has a bar shape extending in a second direction perpendicular to the first direction.
3. The display apparatus according to clause 2, wherein in a plane of the device substrate, the upper opening of the upper barrier pattern has a symmetrical shape with respect to an axis passing through the lens central point in the second direction.
4. The display apparatus according to any one of the preceding clauses, wherein a cross-section of the pixel lens in the third direction has a semi-circular shape.
5. The display apparatus according to any one of the preceding clauses, wherein a size of a lower surface of the pixel lens toward the device substrate is larger than a size of the upper opening of the upper barrier pattern.
6. The display apparatus according to any one of the preceding clauses, further comprising a lower barrier pattern disposed above the first light-emitting device and below the upper barrier pattern,
   wherein the lower barrier pattern comprises a lower opening overlapping the upper opening and the pixel lens, and
   wherein a size of the upper opening is smaller than a size of the lower opening.
7. The display apparatus according to any one of the preceding clauses, wherein the pixel area of each of the plurality of pixels further includes a second emission area, the second emission area displaying a same color as the first emission area,
   wherein the display apparatus further comprises a second light-emitting device, the second light-emitting device disposed between the device substrate and the upper barrier pattern and overlapping the second emission area,
   wherein the second emission area at least partially overlaps the upper opening of the upper barrier pattern, and
   wherein the virtual center line is located between the first emission area and the second emission area.
8. The display apparatus according to clause 7, wherein in a plane of the device substrate, the first emission area has a shape symmetrical to the second emission area with respect to an axis passing through the lens central point in a second direction.
9. The display apparatus according to clause 7, further comprising:
   a planarization layer disposed between the device substrate and the first light-emitting device and between the device substrate and the second light-emitting device;
   a first driving circuit disposed between the device substrate and the planarization layer, the first driving circuit electrically connected to the first light-emitting device; and
   a second driving circuit disposed between the device substrate and the planarization layer, the second driving circuit electrically connected to the second light-emitting device,
   wherein the first driving circuit and the second driving circuit are disposed in the pixel area and insulated from each other.
10. The display apparatus according to clause 9, wherein the first driving circuit has a same configuration as the second driving circuit.
11. The display apparatus according to clause 9, wherein a first image realized by first light emitted from the first emission area of each of the plurality of pixels comprises different information from a second image realized by second light emitted from the second emission area of each of the plurality of pixels.
12. A display apparatus, comprising:
   a device substrate on which a plurality of pixels are disposed, wherein a pixel area of each of the plurality of pixels includes a first emission area and a second emission area;
   an upper barrier pattern comprising a plurality of upper openings, wherein each of the plurality of upper openings at least partially overlaps the first emission area and the second emission area of one of the plurality of pixels; and
   a plurality of pixel lenses disposed on the upper barrier pattern, wherein each of the plurality of pixel lenses overlaps one of the plurality of upper openings of the upper barrier pattern,
   wherein in the pixel area of each of the plurality of pixels, a lens central point of a pixel lens of the plurality of pixel lenses is located between the first emission area and the second emission area in a first direction,
   wherein in a plane of the device substrate, a spacing between adjacent pixel lenses of the plurality of pixel lenses in the first direction is same as a spacing between adjacent pixel lenses of the plurality of pixel lenses in a second direction perpendicular to the first direction, and
   wherein a spacing between adjacent pixel lenses of the plurality of pixel lenses in a direction inclined to the first direction and the second direction is smaller than the spacing between the adjacent pixel lenses in the second direction.
13. A display apparatus, comprising:
   a device substrate on which a plurality of pixels are disposed, wherein a pixel area of each of the plurality of pixels includes a first emission area and a second emission area;
   a plurality of touch electrodes, wherein a space between adjacent touch electrodes of the plurality of touch electrodes at least partially overlaps the first emission area and the second emission area of one of the plurality of pixels; and
   a plurality of pixel lenses disposed on the plurality of touch electrodes, wherein each of the plurality of pixel lenses overlaps the space between the adjacent touch electrodes,
   wherein in the pixel area of each of the plurality of pixels, a lens central point of a pixel lens of the plurality of pixel lenses is located between the first emission area and the second emission area in a first direction,
   wherein in a plane of the device substrate, a spacing between adjacent pixel lenses of the plurality of pixel lenses in the first direction is same as a spacing between adjacent pixel lenses of the plurality of pixel lenses in a second direction perpendicular to the first direction, and
   wherein a spacing between adjacent pixel lenses of the plurality of pixel lenses in a direction inclined to the first direction and the second direction is smaller than the spacing between the adjacent pixel lenses in the second direction.
14. The display apparatus according to clause 13, wherein in the pixel area of each of the plurality of pixels, a length of the second emission area is same as a length of the first emission area in the first direction and the second direction.
15. The display apparatus according to clause 13, wherein in the pixel area of each of the plurality of pixels, the first emission area and the second emission area are disposed side by side in a direction inclined to the first direction and the second direction.
16. The display apparatus according to clause 13, wherein the plurality of pixels comprise a first pixel, a second pixel, and a third pixel that display different colors,
   wherein a pixel area of the second pixel is disposed side by side with a pixel area of the first pixel in a direction inclined to the first direction and the second direction,
   wherein a pixel area of the third pixel is disposed side by side with the pixel area of the first pixel in the first direction, and
   wherein the pixel area of the first pixel is repeatedly disposed in the second direction.
17. The display apparatus according to any one of clauses 12-16, further comprising a barrier passivation layer disposed between the upper barrier pattern and the plurality of pixel lenses.
18. The display apparatus according to clause 13, wherein a first image realized by first light emitted from the first emission area of each of the plurality of pixels comprises different information from a second image realized by second light emitted from the second emission area of each of the plurality of pixels.
19. A vehicle, comprising the display apparatus according to any one of clauses 1-18.
20. The vehicle according to clause 19, wherein the display apparatus is disposed in front of a driver seat and a passenger seat.

In the result, the display apparatus according to examples of the present disclosure can comprise the light-emitting device on the emission area of the device substrate, the upper barrier pattern on the light-emitting device and the pixel lens on the upper barrier pattern, wherein the upper barrier pattern can include the upper opening overlapping with the pixel lens, and wherein the virtual center line passing through the lens central point of the pixel lens in a direction perpendicular to the upper surface of the device substrate toward the upper barrier pattern can be disposed outside the emission area. Thus, in the display apparatus according to examples of the present disclosure, the image provided to the user cannot be recognized by people located in a different direction from the user. And, in the display apparatus according to examples of the present disclosure, the quality of the image provided in an inclined direction with respect to the virtual center line can be improved. Thereby, in the display apparatus according to examples of the present disclosure, the accidents due to gaze dispersion of the people located around the user can be prevented. And, in the display apparatus according to examples of the present disclosure, the low-power operation can be possible, and the power consumption can be reduced.

## Claims

1. A display apparatus, comprising:
a device substrate on which a plurality of pixels are disposed;
a first light-emitting device overlapping a first emission area included in a pixel area of each of the plurality of pixels;
an upper barrier pattern disposed on the first light-emitting device, the upper barrier pattern comprising an upper opening; and
a pixel lens disposed on the upper barrier pattern, the pixel lens overlapping the upper opening of the upper barrier pattern,
wherein the first emission area at least partially overlaps the upper opening of the upper barrier pattern, and
wherein a virtual center line passing through a lens central point of the pixel lens in a third direction perpendicular to the device substrate toward the upper barrier pattern is located outside the first emission area.

2. The display apparatus according to claim 1, wherein in a plane of the device substrate, the virtual center line is spaced apart from the first emission area in a first direction, and each of the first emission area, the upper opening and the pixel lens has a bar shape extending in a second direction perpendicular to the first direction.

3. The display apparatus according to claim 2, wherein in a plane of the device substrate, the upper opening of the upper barrier pattern has a symmetrical shape with respect to an axis passing through the lens central point in the second direction.

4. The display apparatus according to claim 1, wherein a cross-section of the pixel lens in the third direction has a semi-circular shape.

5. The display apparatus according to any one of the preceding claims , wherein a size of a lower surface of the pixel lens toward the device substrate is larger than a size of the upper opening of the upper barrier pattern.

6. The display apparatus according to any one of the preceding claims , further comprising a lower barrier pattern disposed above the first light-emitting device and below the upper barrier pattern,
wherein the lower barrier pattern comprises a lower opening overlapping the upper opening and the pixel lens, and
wherein a size of the upper opening is smaller than a size of the lower opening.

7. The display apparatus according to any one of the preceding claims, wherein the pixel area of each of the plurality of pixels further includes a second emission area, the second emission area displaying a same color as the first emission area,
wherein the display apparatus further comprises a second light-emitting device, the second light-emitting device disposed between the device substrate and the upper barrier pattern and overlapping the second emission area,
wherein the second emission area at least partially overlaps the upper opening of the upper barrier pattern, and
wherein the virtual center line is located between the first emission area and the second emission area.

8. The display apparatus according to claim 7, wherein in a plane of the device substrate, the first emission area has a shape symmetrical to the second emission area with respect to an axis passing through the lens central point in a second direction.

9. The display apparatus according to claim 7, further comprising:
a planarization layer disposed between the device substrate and the first light-emitting device and between the device substrate and the second light-emitting device;
a first driving circuit disposed between the device substrate and the planarization layer, the first driving circuit electrically connected to the first light-emitting device; and
a second driving circuit disposed between the device substrate and the planarization layer, the second driving circuit electrically connected to the second light-emitting device,
wherein the first driving circuit and the second driving circuit are disposed in the pixel area and insulated from each other.

10. The display apparatus according to claim 9, wherein the first driving circuit has a same configuration as the second driving circuit; or optionally wherein a first image realized by first light emitted from the first emission area of each of the plurality of pixels comprises different information from a second image realized by second light emitted from the second emission area of each of the plurality of pixels.

11. A display apparatus, comprising:
a device substrate on which a plurality of pixels are disposed, wherein a pixel area of each of the plurality of pixels includes a first emission area and a second emission area;
an upper barrier pattern comprising a plurality of upper openings, wherein each of the plurality of upper openings at least partially overlaps the first emission area and the second emission area of one of the plurality of pixels; and
a plurality of pixel lenses disposed on the upper barrier pattern, wherein each of the plurality of pixel lenses overlaps one of the plurality of upper openings of the upper barrier pattern,
wherein in the pixel area of each of the plurality of pixels, a lens central point of a pixel lens of the plurality of pixel lenses is located between the first emission area and the second emission area in a first direction,
wherein in a plane of the device substrate, a spacing between adjacent pixel lenses of the plurality of pixel lenses in the first direction is same as a spacing between adjacent pixel lenses of the plurality of pixel lenses in a second direction perpendicular to the first direction, and
wherein a spacing between adjacent pixel lenses of the plurality of pixel lenses in a direction inclined to the first direction and the second direction is smaller than the spacing between the adjacent pixel lenses in the second direction.

12. A display apparatus, comprising:
a device substrate on which a plurality of pixels are disposed, wherein a pixel area of each of the plurality of pixels includes a first emission area and a second emission area;
a plurality of touch electrodes, wherein a space between adjacent touch electrodes of the plurality of touch electrodes at least partially overlaps the first emission area and the second emission area of one of the plurality of pixels; and
a plurality of pixel lenses disposed on the plurality of touch electrodes, wherein each of the plurality of pixel lenses overlaps the space between the adjacent touch electrodes,
wherein in the pixel area of each of the plurality of pixels, a lens central point of a pixel lens of the plurality of pixel lenses is located between the first emission area and the second emission area in a first direction,
wherein in a plane of the device substrate, a spacing between adjacent pixel lenses of the plurality of pixel lenses in the first direction is same as a spacing between adjacent pixel lenses of the plurality of pixel lenses in a second direction perpendicular to the first direction, and
wherein a spacing between adjacent pixel lenses of the plurality of pixel lenses in a direction inclined to the first direction and the second direction is smaller than the spacing between the adjacent pixel lenses in the second direction.

13. The display apparatus according to claim 12, wherein in the pixel area of each of the plurality of pixels, a length of the second emission area is same as a length of the first emission area in the first direction and the second direction; or optionally
wherein in the pixel area of each of the plurality of pixels, the first emission area and the second emission area are disposed side by side in a direction inclined to the first direction and the second direction; or optionally
wherein the plurality of pixels comprise a first pixel, a second pixel, and a third pixel that display different colors,
wherein a pixel area of the second pixel is disposed side by side with a pixel area of the first pixel in a direction inclined to the first direction and the second direction,
wherein a pixel area of the third pixel is disposed side by side with the pixel area of the first pixel in the first direction, and
wherein the pixel area of the first pixel is repeatedly disposed in the second direction.

14. The display apparatus according to any one of claims 11-13, further comprising a barrier passivation layer disposed between the upper barrier pattern and the plurality of pixel lenses; and optionally
wherein a first image realized by first light emitted from the first emission area of each of the plurality of pixels comprises different information from a second image realized by second light emitted from the second emission area of each of the plurality of pixels.

15. A vehicle, comprising the display apparatus according to claim 1; and optionally wherein the display apparatus is disposed in front of a driver seat and a passenger seat.
